# EUROPÄISCHE PATENTANMELDUNG

(11) **EP 3 352 014 A1**
(43) Veröffentlichungstag der Anmeldung: **25.07.2018**
(21) Anmeldenummer: 17186553.8
(22) Anmeldetag: 17.08.2017
(51) Int. Cl.: G03F 7/20, G02B 5/08, G02B 1/18

(54) **OPTISCHE ANORDNUNG, INSBESONDERE IN EINER PROJEKTIONSBELICHTUNGSANLAGE FÜR DIE EUV-LITHOGRAPHIE**

(30) Priorität: 15.09.2016 DE 102016217633
(71) Anmelder: Carl Zeiss SMT GmbH, 73447 Oberkochen (DE)
(72) Erfinder: Ehm, Dirk Heinrich, 66701 Beckingen (DE); Kaller, Julian, 89551 Königsbronn (DE)
(74) Vertreter: Carl Zeiss AG - Patentabteilung

(57) **Zusammenfassung**

Die vorliegende Erfindung betrifft eine optische Anordnung, insbesondere in einer Projektionsbelichtungsanlage für die EUV-Lithographie, mit einem Gehäuse, in welchem eine Mehrzahl von optischen Elementen angeordnet ist, und einer Mehrzahl von innerhalb dieses Gehäuses angeordneten Teilgehäusen (201-205, 301-304), wobei jedes dieser Teilgehäuse jeweils wenigstens eines der optischen Elemente sowie ein im Betrieb des optischen Systems auf das optische Element auftreffendes Strahlenbündel umgibt, wobei der Innenraum des jeweiligen Teilgehäuses (201-205, 301-304) mit dem Außenraum des jeweiligen Teilgehäuses über wenigstens eine Öffnung in Verbindung steht, wobei jedem dieser Teilgehäuse (201-205, 301-304) eine separate Gaszufuhr zugeordnet ist, über welche der Innenraum des betreffenden Teilgehäuses (201-205, 301-304) individuell mit einer eigenen Gasatmosphäre beaufschlagbar ist.

## Beschreibung

### HINTERGRUND DER ERFINDUNG

### Gebiet der Erfindung

Die vorliegende Erfindung betrifft eine optische Anordnung, insbesondere in einer Projektionsbelichtungsanlage für die EUV-Lithographie.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

In für den EUV-Bereich ausgelegten Projektionsbelichtungsanlagen, d.h. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet. Da die Lebensdauer der Spiegel bzw. der für den Betrieb unter EUV-Bedingungen ausgelegten Projektionsbelichtungsanlage durch kontaminierende Teilchen oder Gase, insbesondere Kohlenwasserstoffverbindungen, begrenzt wird, ist ein Betrieb der Projektionsbelichtungsanlage bzw. einzelner Gehäuseteile unter Vakuumbedingungen (z.B. bei Gesamtdrücken von 10⁻² mbar oder darunter) erforderlich.

Dabei tritt in der Praxis jedoch das Problem auf, dass die sich im System ausbreitenden Kontaminanten auf den Oberflächen der optischen Elemente anhaften können, was wiederum eine Beeinträchtigung der optischen Eigenschaften der Elemente, also insbesondere einen Reflexionsverlust der Spiegel, zur Folge hat.

Ansätze zur Überwindung dieses Problems beinhalten insbesondere, eine Art "Mini-Umgebung" (engl.: "mini environment") um die optische Oberflächen der reflektiven optischen Elementen sowie den optischen Strahlengang herum zu erzeugen, um eine Reduzierung der Anhaftung von Kontaminanten auf der optischen Oberfläche zu erzielen.

Ein hierbei auftretendes weiteres Problem ist jedoch, dass die möglichen, innerhalb der Projektionsbelichtungsanlage auftretenden Kontaminationen sowie deren Auswirkungen abhängig von der Position der optischen Elemente innerhalb der Projektionsbelichtungsanlage variieren.

Konkret spielen z.B. Kontaminationen von Zinn (Sn) aus einer Plasmalichtquelle einer für den Betrieb im EUV ausgelegten Projektionsbelichtungsanlage typischerweise lediglich in der Lichtquelle selbst sowie gegebenenfalls noch in der Beleuchtungseinrichtung eine Rolle. Infolgedessen erweist sich etwa eine gezielt auf die Reduzierung von Zinn-Kontaminationen ausgerichtete Wahl der Gasatmosphäre in der o.g. "Mini-Umgebung", welche den Erfordernissen in der Lichtquelle bzw. der Beleuchtungseinrichtung Rechnung trägt, unter Umständen hinsichtlich des Projektionsobjektivs als ungeeignet und kann z.B. auf Seiten des Projektionsobjektivs einen unnötigen zusätzlichen Transmissionsverlust zur Folge haben.

Das vorstehend beschriebene Problem der Existenz unterschiedlicher Randbedingungen bzw. Anforderungen in voneinander verschiedenen Bereichen der Projektionsbelichtungsanlage tritt nicht nur hinsichtlich der besagten Gasatmosphäre auf, sondern auch im Hinblick auf Deckschichten (engl.: "cap layer"), welche als Kontaminationsschutz auf den einzelnen optischen Elementen ausgebildet werden. Auch insoweit kann nämlich ein bestimmtes (z.B. zur Vermeidung von Zinnablagerungen eingesetztes) Deckschichtmaterial, welches beispielsweise in der Lichtquelle bzw. der Beleuchtungseinrichtung für einen wirksamen Kontaminationsschutz sorgt, beim Einsatz im Projektionsobjektiv als zusätzliche Schicht zu einer unerwünschten EUV-Absorption und damit einer Verringerung der gesamten Systemtransmission führen.

Zum Stand der Technik wird lediglich beispielhaft auf DE 10 2006 044 591 A1 und DE 10 2009 029 282 A1 verwiesen.

### ZUSAMMENFASSUNG DER ERFINDUNG

Es ist eine Aufgabe der vorliegenden Erfindung, eine optische Anordnung in einem optischen System, insbesondere in einer Projektionsbelichtungsanlage für die EUV-Lithographie, bereitzustellen, welche einen wirksamen Kontaminationsschutz unter möglichst geringer Beeinträchtigung der Transmissionseigenschaften der Projektionsbelichtungsanlage ermöglicht.

Diese Aufgabe wird gemäß den Merkmalen der unabhängigen Patentansprüche gelöst.

Gemäß einem Aspekt der Erfindung weist eine optische Anordnung in einem optischen System, insbesondere in einer Projektionsbelichtungsanlage für die EUV-Lithographie, auf:
- ein Gehäuse, in welchem eine Mehrzahl von optischen Elementen angeordnet ist; und
- eine Mehrzahl von innerhalb dieses Gehäuses angeordneten Teilgehäusen, wobei jedes dieser Teilgehäuse jeweils wenigstens eines der optischen Elemente sowie ein im Betrieb des optischen Systems auf das optische Element auftreffendes Strahlenbündel umgibt, wobei der Innenraum des jeweiligen Teilgehäuses mit dem Außenraum des jeweiligen Teilgehäuses über wenigstens eine Öffnung in Verbindung steht;
- wobei jedem dieser Teilgehäuse eine separate Gaszufuhr zugeordnet ist, über welche der Innenraum des betreffenden Teilgehäuses individuell mit einer eigenen Gasatmosphäre beaufschlagbar ist.

Der vorliegenden Erfindung liegt insbesondere das Konzept zugrunde, ausgehend von dem für sich bekannten Prinzip der Bereitstellung einer mit einer geeigneten Gasatmosphäre beaufschlagbaren "Mini-Umgebung" innerhalb eines Gehäuses der Projektionsbelichtungsanlage einzelne Bereiche dieser Mini-Umgebung mit voneinander verschiedener Gasatmosphäre zu beaufschlagen, um den jeweils unterschiedlichen Randbedingungen bzw. Erfordernissen innerhalb der Projektionsbelichtungsanlage Rechnung zu tragen.

Mit anderen Worten beinhaltet die Erfindung insbesondere das Konzept, innerhalb einer die optischen Elemente bzw. den Nutzstrahlengang umgebenden Mini-Umgebung unterschiedliche Teilvolumina zu realisieren, wobei jedes dieser Teilvolumina eines oder mehrere optische Elemente umfasst und wobei die jeweilige Gasatmosphäre in diesen Teilvolumina auf die dort vorliegenden speziellen Gegebenheiten bzw. Anforderungen abgestimmt ist.

Unter einer "Mini-Umgebung" wird im Sinne der vorliegenden Anmeldung ein baulich bzw. räumlich abgetrennter Bereich verstanden, welcher die separate Einstellung der Partialdrücke von in diesem Bereich enthaltenen Gasen bzw. chemischen Elementen (also die Schaffung einer eigenen Gasatmosphäre) ermöglicht. Dabei kann dieser räumlich abgetrennte Bereich Öffnungen aufweisen, um eine Einstellung der Partialdrücke und/oder eine Bewegung der optischen Elemente zu ermöglichen.

Gemäß einer Ausführungsform erfolgt die Beaufschlagung der Teilgehäuse mit einem Überdruck relativ zum Außenraum des jeweiligen Teilgehäuses.

Gemäß einer Ausführungsform erfolgt für wenigstens zwei dieser Teilgehäuse die Beaufschlagung mit voneinander verschiedenen Gasen.

Gemäß einer Ausführungsform erfolgt die Beaufschlagung wenigstens eines dieser Teilgehäuse mit Helium.

Gemäß einer Ausführungsform umgibt dieses Teilgehäuse wenigstens eines der optischen Elemente in der Beleuchtungseinrichtung der Projektionsbelichtungsanlage.

Gemäß einer Ausführungsform erfolgt die Beaufschlagung wenigstens eines dieser Teilgehäuse mit Wasserstoff.

Gemäß einer Ausführungsform erfolgt die Beaufschlagung wenigstens eines dieser Teilgehäuse unter Zugabe von Sauerstoff, Stickstoff, Kohlendioxid, Xenon, Argon, Krypton, Chlor, Brom oder Mischungen davon.

Gemäß einer Ausführungsform umgibt dieses Teilgehäuse - bzw. wenigstens eines der Teilgehäuse - wenigstens eines der optischen Elemente im Projektionsobjektiv der Projektionsbelichtungsanlage.

Gemäß einer Ausführungsform umgibt dieses Teilgehäuse - bzw. wenigstens eines der Teilgehäuse - einen Kollektorspiegel einer Lichtquelle, insbesondere den Kollektorspiegel einer Plasmalichtquelle einer für den Betrieb im EUV ausgelegten Projektionsbelichtungsanlage.

Gemäß einem weiteren Aspekt beinhaltet die vorliegende Erfindung auch das Konzept, eine auf einem oder mehreren optischen Elementen innerhalb jeweils eines der o.g. Teilvolumina befindliche Kontaminationsschutzdeckschicht hinsichtlich des jeweiligen Schichtmaterials abhängig von den konkreten Gegebenheiten (insbesondere etwa der Position innerhalb der Projektionsbelichtungsanlage, der in dem betreffenden Bereich zu berücksichtigendem Kontaminanten etc.) auszugestalten. Mit anderen Worten beinhaltet die Erfindung auch das Konzept, in den die o.g. "Mini-umgebung" unterteilenden Teilgehäusen voneinander verschiedene Kontaminationsschutzdeckschichten auf den betreffenden optischen Elementen bzw. Spiegeln vorzusehen, wobei zum einen die jeweils geeignete Kontaminationsschutzdeckschicht abhängig von den zu erwartenden Kontaminationspartikeln gewählt werden kann, zum anderen aber auch innerhalb eines bestimmten Teilvolumens eine jeweils günstige bzw. optimale Abstimmung von Gasatmosphäre und Kontaminationsschutzdeckschicht aufeinander vorgenommen werden kann.

Gemäß einer Ausführungsform weist wenigstens ein in einem ersten Teilgehäuse befindliches optisches Element eine erste Kontaminationsschutzdeckschicht auf, und wenigstens ein in einem zweiten Teilgehäuse befindliches optisches Element weist eine zweite Kontaminationsschutzdeckschicht auf, wobei diese Kontaminationsschutzdeckschichten sich hinsichtlich des jeweiligen Schichtmaterials voneinander unterscheiden.

Die Ausgestaltung von optischen Elementen mit voneinander verschiedenen Kontaminationsschutzdeckschicht-Materialien ist auch unabhängig von der Bereitstellung unterschiedlicher Gasvolumina vorteilhaft. Gemäß einem weiteren Aspekt betrifft die Erfindung daher auch eine optische Anordnung in einem optischen System, insbesondere in einer Projektionsbelichtungsanlage für die EUV-Lithographie, mit:
- einem Gehäuse, in welchem eine Mehrzahl von optischen Elementen angeordnet ist; und
- einer Mehrzahl von innerhalb dieses Gehäuses angeordneten Teilgehäusen;
- wobei wenigstens ein in einem ersten Teilgehäuse befindliches optisches Element eine erste Kontaminationsschutzdeckschicht aufweist, und
- wobei wenigstens ein in einem zweiten Teilgehäuse befindliches optisches Element eine zweite Kontaminationsschutzdeckschicht aufweist, wobei diese Kontaminationsschutzdeckschichten sich hinsichtlich des jeweiligen Schichtmaterials voneinander unterscheiden.

Gemäß einer Ausführungsform weist die erste Kontaminationsschutzdeckschicht und/oder die zweite Kontaminationsschutzdeckschicht ein Schichtmaterial aus der Gruppe auf, die Yttrium (Y), Cer (Ce), Zirkon (Zr), Niob (Nb), Silizium (Si), Titan (Ti), Vanadium (V), Molybdän (Mo), Mangan (Mn), Aluminium (Al), Wolfram (W), Chrom (Cr), Lanthan (La), Kobalt (Co), Ruthenium (Ru), Bor (B), Hafnium (Hf), Uran (U), Beryllium (Be) sowie Oxide, Nitride, Karbide, Silikate und Boride aus diesen Materialien enthält.

In einer konkreten Ausführungsform kann z.B. die erste Kontaminationsschutzdeckschicht Zirkonoxid (ZrO₂) und die zweite Kontaminationsschutzdeckschicht Ruthenium (Ru) aufweisen.

Gemäß einer Ausführungsform umgibt das erste Teilgehäuse wenigstens eines der optischen Elemente in der Beleuchtungseinrichtung der Projektionsbelichtungsanlage.

Gemäß einer Ausführungsform umgibt das zweite Teilgehäuse wenigstens eines der optischen Elemente im Projektionsobjektiv der Projektionsbelichtungsanlage.

Gemäß einer Ausführungsform ist die optische Anordnung für eine Arbeitswellenlänge von weniger als 15 nm ausgelegt.

Die Erfindung betrifft weiter eine mikrolithographische Projektionsbelichtungsanlage, mit einer Beleuchtungseinrichtung und einem Projektionsobjektiv, wobei die Beleuchtungseinrichtung und/oder das Projektionsobjektiv eine optische Anordnung mit den vorstehend beschriebenen Merkmalen aufweist, sowie ein Verfahren zur mikrolithographischen Herstellung mikrostrukturierter Bauelemente.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1: eine schematische Darstellung zur Erläuterung eines prinzipiellen möglichen Aufbaus einer mikrolithographischen Projektionsbelichtungsanlage;
- Figur 2a-b: schematische Darstellungen zur Erläuterung einer möglichen Ausführungsform der Erfindung;
- Figur 3a-b: schematische Darstellungen zur Erläuterung einer weiteren möglichen Ausführungsform der Erfindung; und
- Figur 4a-b: schematische Darstellungen zur Erläuterung eines weiteren Aspekts der vorliegenden Erfindung.

### DETAILLIERTE BESCHREIBUNG BEVORZUGTER AUSFÜHRUNGSFORMEN

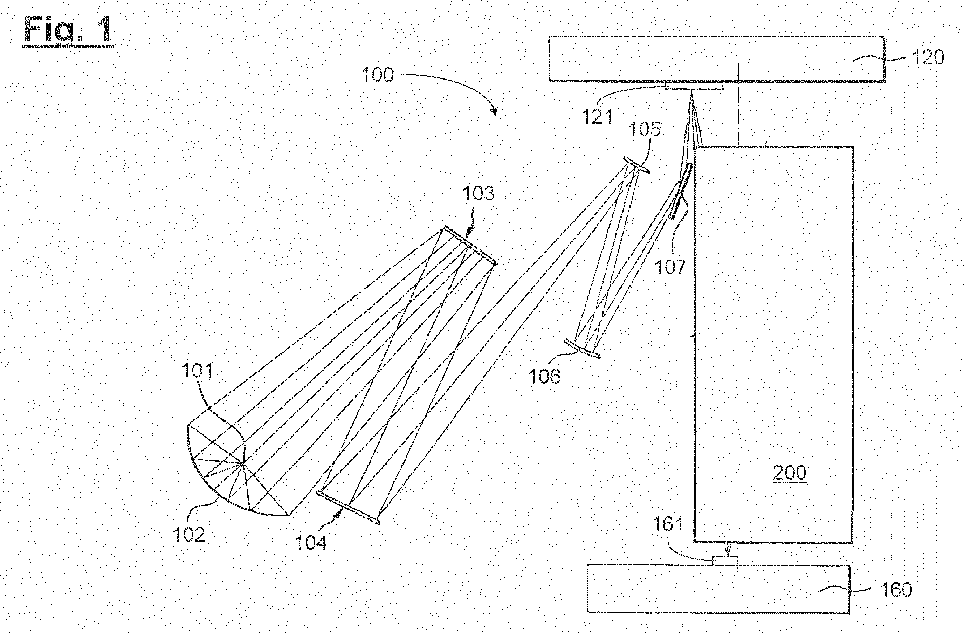

Fig. 1 zeigt eine schematische Darstellung eines prinzipiellen möglichen Aufbaus einer für den Betrieb im EUV ausgelegten Projektionsbelichtungsanlage, in welcher die vorliegende Erfindung realisierbar ist.

Gemäß Fig. 1 weist eine Beleuchtungseinrichtung in einer für EUV ausgelegten Projektionsbelichtungsanlage 100 einen Feldfacettenspiegel 103 und einen Pupillenfacettenspiegel 104 auf. Auf den Feldfacettenspiegel 103 wird das Licht einer Lichtquelleneinheit, welche eine Plasmalichtquelle 101 und einen Kollektorspiegel 102 umfasst, gelenkt. Im Lichtweg nach dem Pupillenfacettenspiegel 104 sind ein erster Teleskopspiegel 105 und ein zweiter Teleskopspiegel 106 angeordnet. Im Lichtweg nachfolgend ist ein Umlenkspiegel 107 angeordnet, der die auf ihn treffende Strahlung auf ein Objektfeld in der Objektebene eines in Fig. 1a lediglich angedeuteten Projektionsobjektivs 200 lenkt. Am Ort des Objektfeldes ist eine reflektive strukturtragende Maske 121 auf einem Maskentisch 120 angeordnet, die mit Hilfe des Projektionsobjektivs 200 in eine Bildebene abgebildet wird, in welcher sich ein mit einer lichtempfindlichen Schicht (Photoresist) beschichtetes Substrat 161 auf einem Wafertisch 160 befindet.

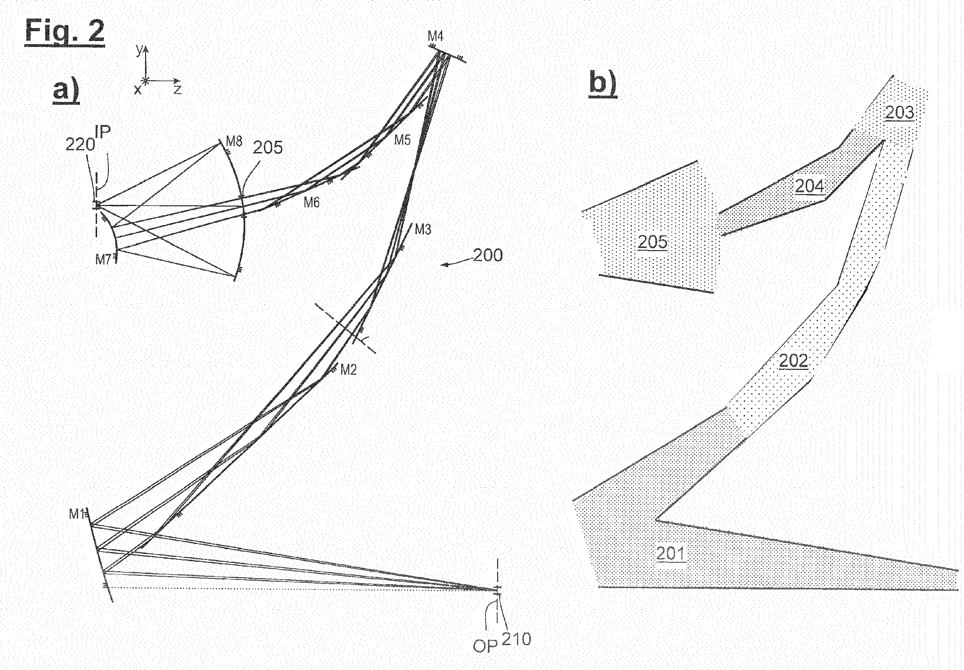

Ein konkretes Ausführungsbeispiel des Projektionsobjektivs 200 ist (ohne dass die Erfindung hierauf beschränkt wäre) in Fig. 2a dargestellt. Hinsichtlich der konkreten Designdaten dieses Ausführungsbeispiels wird auf DE 10 2014 208 770 A1 (siehe dort Fig. 2 und Tabellen 1 bis 6) verwiesen. Die Erfindung ist nicht auf die Realisierung in einem Projektionsobjektiv mit dem in Fig. 2a gezeigten konkreten Aufbau beschränkt. In weiteren Ausführungsbeispielen kann die Erfindung auch in Projektionsobjektiven mit anderem Aufbau (z.B. wie in DE 10 2012 202 675 A1 gezeigt) oder in anderen optischen Systemen realisiert werden.

Das Projektionsobjektiv 200 bildet ein in der Objektebene "OP" befindliches Objektfeld 210 auf ein in der Bildebene "IP" befindliches Bildfeld 220 ab und kann z.B. gemäß dem konkreten Ausführungsbeispiel von Fig. 2a beispielsweise acht Spiegel M1 bis M8 aufweisen, von denen die Spiegel M1, M4, M7 und M8 als Spiegel für senkrechten Einfall des Beleuchtungslichts (mit einem Einfallswinkel kleiner als 45°) ausgeführt sind und einen Reflexionsschichtstapel aus Molybdän (Mo)- sowie Silizium (Si)-Schichten aufweisen können. Mit "205" ist eine in dem Spiegel M8 befindliche Durchtrittsöffnung zur Ermöglichung des Durchtritts des Abbildungslichtes bezeichnet.

Die Spiegel M2, M3, M5 und M6 sind als Spiegel für streifenden Einfall des Beleuchtungslichts (mit Einfallswinkeln größer als 60°) ausgeführt und können eine Beschichtung mit beispielsweise einer Lage aus Ruthenium (Ru) aufweisen.

Erfindungsgemäß ist nun, wie lediglich schematisch in Fig. 2b dargestellt, eine Mehrzahl von Teilgehäusen 201-205 vorgesehen, von denen jedes jeweils einen oder mehrere der Spiegel der Projektionsbelichtungsanlage aufnimmt, wobei diese Teilgehäuse 201-205 mit voneinander verschiedener Gasatmosphäre beaufschlagbar sind. Hierzu ist jedem der Teilgehäuse 201-205 jeweils eine (in Fig. 2b nicht dargestellte) Gaszufuhr zugeordnet, über welche das betreffende Teilgehäuse mit einem oder mehreren Gasen befüllbar ist. Vorzugsweise befindet sich der jeweilige Übergangsbereich zwischen entlang des Strahlengangs aufeinanderfolgenden Teilgehäusen jeweils im Bereich einer Einschnürung des optischen Strahlengangs, wodurch die bauliche Separierung der durch die Teilgehäuse 201-205 bereitgestellten Gasvolumina vereinfacht wird.

Es ist darauf hinzuweisen, dass die Trennung der vorstehend beschriebenen Gasvolumina gemäß der Erfindung derart realisiert wird, dass jeweils eine Durchmischung der betreffenden, in unterschiedlichen Teilgehäusen 201-205 befindlichen Gase vermieden wird. Diese Trennung bzw. Verhinderung der Durchmischung wird zum Teil durch die jeweiligen Teilgehäuse 201-205 befindliche Wandabschnitte und im Übrigen durch Einstellung geeigneter Druckunterschiede zwischen den voneinander zu trennenden Gasvolumina erzielt. Insbesondere wird jedes der den einzelnen Teilgehäusen 201-205 zugeordneten Gasvolumina gegenüber der Außenumgebung auf einen definierten Überdruck gesetzt mit der Folge, dass ein Gasübertritt von den betreffenden Gasvolumina aus lediglich noch durch (vergleichsweise vernachlässigbare) Diffusionsprozesse erfolgen kann.

Die vorstehend beschriebene Unterteilung in einzelne Teilgehäuse 201-205 erfolgt vorzugsweise in solcher Weise, dass die einzelnen Spiegel jeweils von einer Gasatmosphäre umgeben werden, die den in dem betreffenden Bereich zu erwartenden Kontaminanten angepasst ist.

Im konkreten Ausführungsbeispiel befindet sich der erste Spiegel M1 im Teilgehäuse 201, die Spiegel M2 und M3 befinden sich im Teilgehäuse 202, der Spiegel M4 befindet sich im Teilgehäuse 203, die Spiegel M5 und M6 befinden sich im Teilgehäuse 204 und die Spiegel M7 und M8 befinden sich im Teilgehäuse 205. Die Erfindung ist jedoch hinsichtlich der konkreten Anzahl der Teilgehäuse sowie deren Zuordnung zu einem oder mehreren Spiegeln der Projektionsbelichtungsanlage nicht weiter eingeschränkt, wobei insbesondere auch jedem einzelnen der Spiegel ein separates Teilgehäuse zugeordnet sein kann.

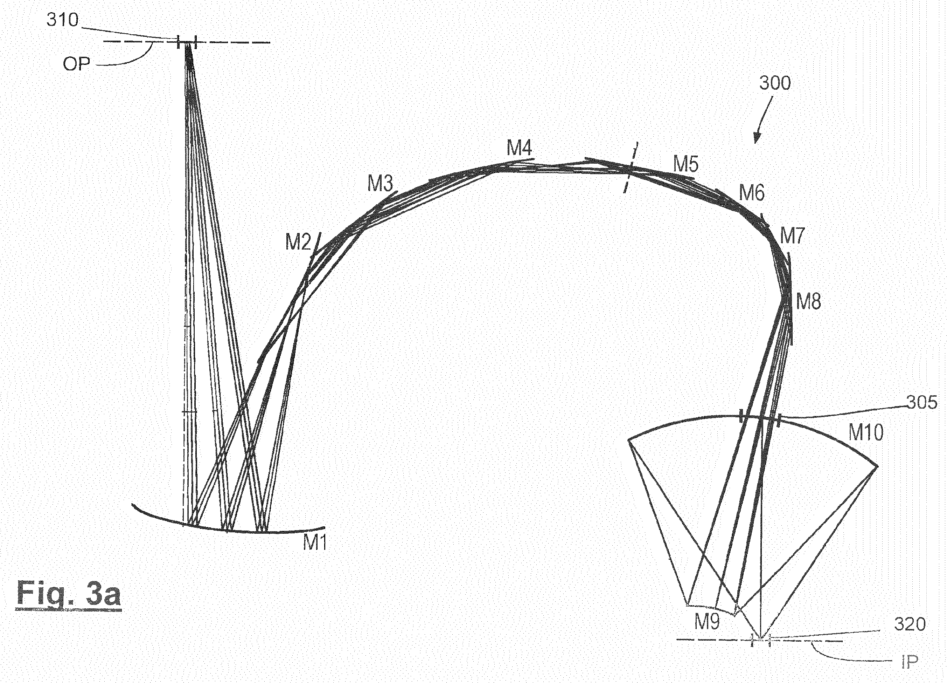

Fig. 3a zeigt ein weiteres konkretes Ausführungsbeispiel eines Projektionsobjektivs 300, in welchem die Erfindung realisierbar ist. Hinsichtlich der konkreten Designdaten dieses Ausführungsbeispiels wird auf DE 10 2015 209 827 A1 (siehe dort Fig. 2 und zugehörige Tabellen 1-9) verwiesen.

Das Projektionsobjektiv 300 bildet ein in der Objektebene "OP" befindliches Objektfeld 310 auf ein in der Bildebene "IP" befindliches Bildfeld 320 ab und weist im konkreten Ausführungsbeispiel zehn Spiegel M1-M10 auf, von denen die Spiegel M1, M9 und M10 als Spiegel für senkrechten Einfall des Beleuchtungslichts (mit einem Einfallswinkel kleiner als 45°) ausgeführt sind und einen Reflexionsschichtstapel z.B. aus Molybdän (Mo)- sowie Silizium (Si)-Schichten aufweisen können. Mit "305" ist eine in dem Spiegel M10 befindliche Durchtrittsöffnung zur Ermöglichung des Durchtritts des Abbildungslichtes bezeichnet.

Die Spiegel M2-M8 sind im Ausführungsbeispiel von Fig. 3a als Spiegel für streifenden Einfall des Beleuchtungslichts (mit Einfallswinkeln größer als 60°) ausgeführt und können eine Beschichtung mit beispielsweise einer Lage aus Ruthenium (Ru) aufweisen.

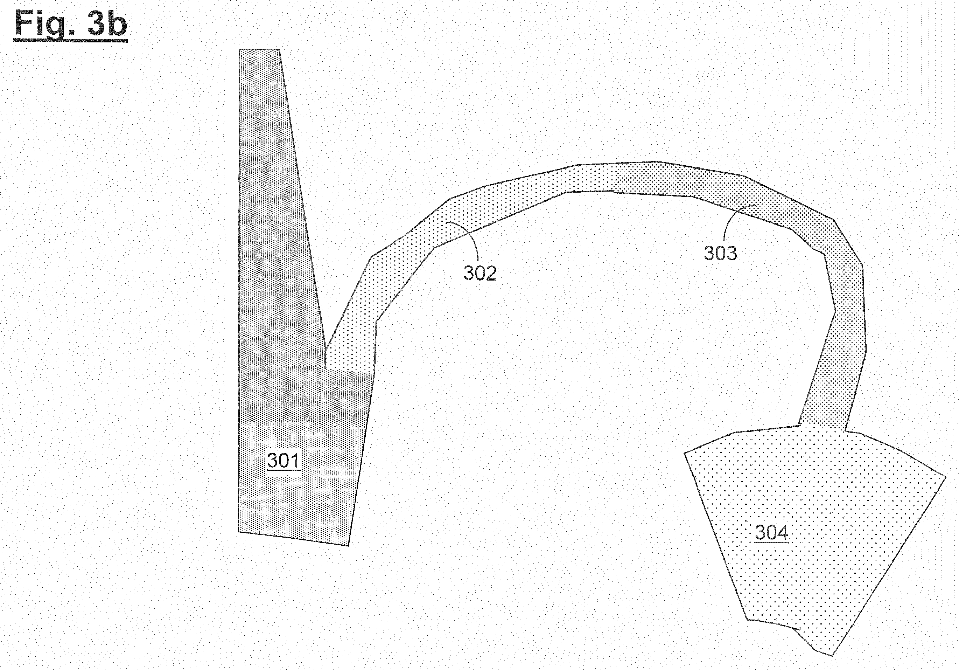

Erfindungsgemäß ist nun auch bei diesem Ausführungsbeispiel, wie lediglich schematisch in Fig. 3b dargestellt, eine Mehrzahl von Teilgehäusen 301-304 vorgesehen, von denen jedes jeweils einen oder mehrere der Spiegel der Projektionsbelichtungsanlage aufnimmt, wobei die Teilgehäuse 301-304 mit voneinander verschiedener Gasatmosphäre beaufschlagbar sind. Insoweit gelten die vorstehenden Ausführungen zum Ausführungsbeispiel von Fig. 2b analog. Im konkreten Ausführungsbeispiel von Fig. 3b befindet sich der erste Spiegel M1 im Teilgehäuse 301, die Spiegel M2, M3 und M4 befinden sich im Teilgehäuse 302, die Spiegel M5, M6, M7 und M8 befinden sich im Teilgehäuse 303 und die Spiegel M9 und M10 befinden sich im Teilgehäuse 304. Auch hier ist die Erfindung hinsichtlich der konkreten Anzahl der Teilgehäuse sowie deren Zuordnung zu einem oder mehreren Spiegeln nicht weiter eingeschränkt, wobei insbesondere auch jedem einzelnen der Spiegel ein separates Teilgehäuse zugeordnet sein kann.

In weiteren Ausführungsformen der Erfindung kann eine Anpassung an die jeweiligen Gegebenheiten in den einzelnen Bereichen der Projektionsbelichtungsanlage bzw. die dort jeweils zu erwartenden Kontaminanten nicht nur hinsichtlich der vorstehend beschriebenen Gasatmosphäre, sondern - alternativ oder zusätzlich hierzu - auch hinsichtlich einer auf den jeweiligen Spiegeln befindlichen Kontaminationsschutzdeckschicht erfolgen.

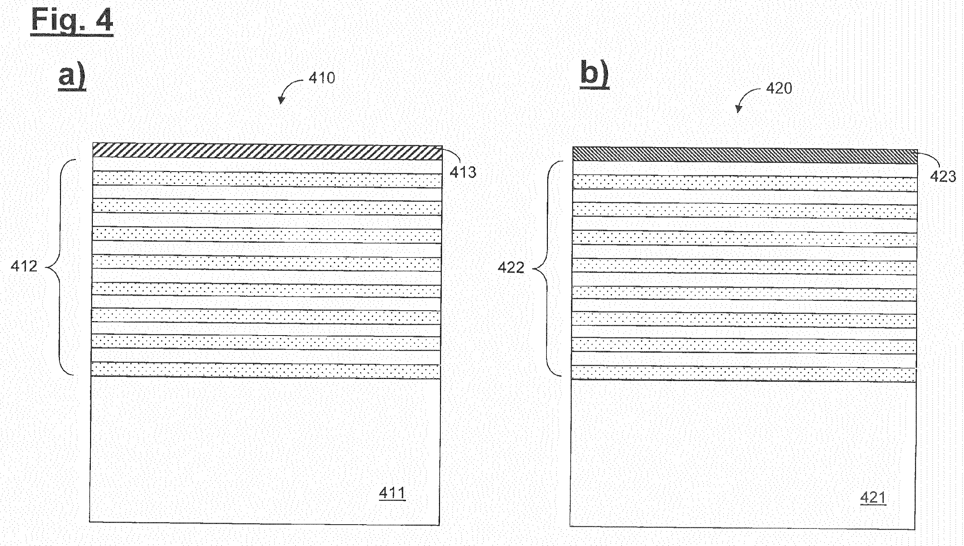

Fig. 4a-b zeigt hierzu in lediglich schematischer und stark vereinfachter Darstellung den Aufbau zweier unterschiedlicher Spiegel 410 und 420, welche jeweils auf einem Spiegelsubstrat 411 bzw. 421 ein Reflexionsschichtsystem 412 bzw. 422 sowie eine Kontaminationsschutzdeckschicht 413 bzw. 423 aufweisen. Die Spiegel 410 und 420 befinden sich an unterschiedlichen Positionen der Projektionsbelichtungsanlage und können jeweils weitere (in Fig. 4a-b nicht dargestellte) Funktionsschichten wie z.B. Barriereschichten, Haftverbesserungsschichten etc. aufweisen.

Gemäß dem in Fig. 4a-b angedeuteten weiteren Aspekt der Erfindung sind nun die Kontaminationsschutzdeckschichten 413 und 423 abhängig von den in dem betreffenden Bereich der Projektionsbelichtungsanlage vorliegenden Gegebenheiten aus voneinander verschiedenen Schichtmaterialien hergestellt.

Wenngleich die erfindungsgemäße Unterteilung in mehrere Teilgehäuse bzw. separate Gasvolumina in Fig. 2a-b bzw. Fig.3a-b lediglich am Beispiel des Projektionsobjektivs erläutert wurde, kann diese Realisierung in der gesamten Projektionsbelichtungsanlage (einschließlich der Lichtquelle sowie der Beleuchtungseinrichtung) erfolgen. Dabei können insbesondere die Spiegel innerhalb der Beleuchtungseinrichtung durch Realisierung eines oder mehrerer Teilgehäuse einzeln oder gruppenweise in separaten Gasvolumina angeordnet sein.

Im Folgenden werden (ohne dass die Erfindung hierauf beschränkt wäre) beispielhafte Gasatmosphären bzw. Kontaminationsschutzdeckschichten genannt, welche je nach Position der betreffenden Spiegel innerhalb der Projektionsbelichtungsanlage geeignet sein können:
In einem konkreten Ausführungsbeispiel können z.B. die Spiegel innerhalb der Beleuchtungseinrichtung eine Kontaminationsschutzdeckschicht aus Zirkonoxid (ZrO₂) aufweisen. Durch die Wahl dieses Schichtmaterials kann der Vorteil erzielt werden, dass (im Unterschied etwa zu Ruthenium (Ru) als Schichtmaterial) eine Anlagerung von Zinn (Sn) auf der jeweiligen Spiegeloberfläche und ein damit einhergehender Reflektivitätsverlust vermieden werden kann. Hingegen können die Spiegel innerhalb des Projektionsobjektivs Ruthenium (Ru) als Schichtmaterial in der Kontaminationsschutzdeckschicht aufweisen, da insoweit von der Plasmalichtquelle herrührende Zinn (Sn)-Kontaminationen keine Rolle mehr spielen und somit auf den Einsatz von Zirkonoxid (ZrO₂) als zusätzliche Schichtlage verzichtet werden kann.

Was nun weiter die erfindungsgemäße Aufteilung in separate Gasvolumina und insoweit geeignete Gasatmosphären betrifft, können in einer vorteilhaften Ausführungsform z.B. die Spiegel innerhalb der Beleuchtungseinrichtung jeweils in einem oder mehreren mit einer Helium (He)-Atmosphäre beaufschlagten Teilgehäuse(n) angeordnet sein, wodurch der Vorteil erzielt werden kann, dass Helium als inertes Gas keine Reaktionen mit Zinn (Sn) zeigt und somit etwaige von der Plasmalichtquelle ausgehende Zinnpartikel keine negativen Auswirkungen in der Beleuchtungseinrichtung haben.

Hingegen können die Spiegel innerhalb des Projektionsobjektivs in Wasserstoff (H₂)-Atmosphäre angeordnet sein, um die vorteilhafte Wirkung des Wasserstoffs zu nutzen, die Spiegel von Kohlenstoffkontaminationen (infolge Plasmaanregung des Kohlenstoffs in Wasserstoffatmosphäre) zu reinigen. Somit kann auf Seiten des Projektionsobjektivs auf eine Gasatmosphäre aus Helium (He) und einen damit grundsätzlich im Vergleich zu Wasserstoff einhergehenden erhöhten Transmissionsverlust verzichtet werden.

In weiteren Ausführungsformen kann auf Seiten des Projektionsobjektivs noch eine aktive Hinzudosierung von Sauerstoff, z.B. in der Größenordnung von 3*10⁻⁵ mbar, erfolgen, um gleichfalls ohne zusätzlichen Reflektivitätsverlust noch einen gewissen Schutz gegenüber etwaigen Zinn (Sn)-Kontaminationspartikeln (welche durch die Sauerstoff-Zugabe oxidiert und an der Bildung von Zinnhydriden gehindert werden) zu gewährleisten. Hingegen kann in der Beleuchtungseinrichtung (infolge des dort in der vorstehenden Ausführungsform bereits eingesetzten Heliums) auf eine aktive Hinzudosierung von Sauerstoff verzichtet werden.

In weiteren Ausführungsformen kann - z.B. im Falle der Beaufschlagung eines oder mehrerer Teilgehäuse z.B. innerhalb der Beleuchtungseinrichtung mit einer Gasatmosphäre aus Helium - ein Einsatz zusätzlicher Reinigungsköpfe zur Reinigung der Spiegeloberflächen von etwaigen Kohlenstoffkontaminationen erfolgen.

Die vorstehend beschriebenen Abstimmungen der Auswahl der innerhalb der Projektionsbelichtungsanlage auf den Spiegeln eingesetzten Kontaminationsschutzdeckschichten sowie Gasvolumina kann nicht nur in Anpassung an die jeweils zu erwartenden Kontaminanten, sondern auch aufeinander erfolgen (d.h. die jeweilige Kontaminationsschutzdeckschicht auf einem Spiegel kann abhängig von der dort eingesetzten Gasatmosphäre gewählt werden) und umgekehrt (d.h. die jeweilige Gasatmosphäre kann an die in dem betreffenden Bereich eingesetzten Schichtmaterialien der Kontaminationsschutzdeckschichten angepasst werden).

Im Bereich der optischen Elemente sind gewisse Spaltabstände der Teilgehäuse zu den jeweiligen optischen Elementen vorgesehen. Diese Spaltabstände können z.B. weniger als 10 mm, insbesondere weniger als 5 mm, weiter insbesondere weniger als 1 mm betragen und ermöglichen zum einen eine Bewegung bzw. Aktuierung der optischen Elemente über die jeweils zugeordneten Manipulatoren. Zum anderen ermöglichen die besagten Spaltabstände auch einen permanenten (Spül-) Gasstrom aus dem Innenbereich des Teilgehäuses in den unter Hochvakuumbedingungen stehenden Außenbereich des Teilgehäuses. Zur Erzeugung bzw. Aufrechterhaltung dieses Spülgasstroms sind an den besagten Außenbereich ein oder mehrere Vakuumpumpen (nicht dargestellt) zur Erzeugung eines Hochvakuums von 10⁻⁵ mbar oder darunter angeschlossen, und es wird eine Gaszuleitung zum Innenbereich des jeweiligen Teilgehäuses bereitgestellt, über welche in diesen Innenbereich das jeweilige Gas (z.B. Wasserstoff oder Helium) eingelassen wird, wobei der (Über)druck beispielsweise im Bereich von 10⁻² mbar liegen kann. Die Gaszuleitung kann insbesondere durch die Reinigungseinheiten oder parallel dazu erfolgen. Erfindungsgemäß kann der Überdruck somit insbesondere so eingestellt sein, dass der Druck im jeweiligen Innenbereich eines Teilgehäuses wenigstens um einen Faktor größer als 1, insbesondere einen Faktor größer als 10, weiter insbesondere einen Faktor größer als 100 höher als im Außenbereich des jeweiligen Teilgehäuses ist. Der sich vom Innenbereich eines Teilgehäuses zum Außenbereich (d.h. dem normalen Vakuumbereich im äußeren Gehäuse) hin einstellende Gasstrom wird durch Vakuumpumpen abgesaugt.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche und deren Äquivalente beschränkt ist.

## Patentansprüche

1. Optische Anordnung in einem optischen System, insbesondere in einer Projektionsbelichtungsanlage für die EUV-Lithographie, mit:
• einem Gehäuse, in welchem eine Mehrzahl von optischen Elementen angeordnet ist; und
• einer Mehrzahl von innerhalb dieses Gehäuses angeordneten Teilgehäusen (201-205, 301-304), wobei jedes dieser Teilgehäuse jeweils wenigstens eines der optischen Elemente sowie ein im Betrieb des optischen Systems auf das optische Element auftreffendes Strahlenbündel umgibt, wobei der Innenraum des jeweiligen Teilgehäuses (201-205, 301-304) mit dem Außenraum des jeweiligen Teilgehäuses über wenigstens eine Öffnung in Verbindung steht;
• wobei jedem dieser Teilgehäuse (201-205, 301-304) eine separate Gaszufuhr zugeordnet ist, über welche der Innenraum des betreffenden Teilgehäuses (201-205, 301-304) individuell mit einer eigenen Gasatmosphäre beaufschlagbar ist.

2. Optische Anordnung nach Anspruch 1, **dadurch gekennzeichnet, dass** die Beaufschlagung der Teilgehäuse (201-205, 301-304) mit einem Überdruck relativ zum Außenraum des jeweiligen Teilgehäuses erfolgt.

3. Optische Anordnung nach Anspruch 1 oder 2, **dadurch gekennzeichnet, dass** für wenigstens zwei dieser Teilgehäuse (201-205, 301-304) die Beaufschlagung mit voneinander verschiedenen Gasen erfolgt.

4. Optische Anordnung nach einem der Ansprüche 1 bis 3, **dadurch gekennzeichnet, dass** die Beaufschlagung wenigstens eines dieser Teilgehäuse (201-205, 301-304) mit Helium erfolgt.

5. Optische Anordnung nach Anspruch 4, **dadurch gekennzeichnet, dass** dieses Teilgehäuse wenigstens eines der optischen Elemente in der Beleuchtungseinrichtung der Projektionsbelichtungsanlage umgibt.

6. Optische Anordnung nach einem der vorhergehenden Ansprüche, **dadurch gekennzeichnet, dass** die Beaufschlagung wenigstens eines dieser Teilgehäuse (201-205, 301-304) mit Wasserstoff erfolgt.

7. Optische Anordnung nach einem der vorhergehenden Ansprüche, **dadurch gekennzeichnet, dass** die Beaufschlagung wenigstens eines dieser Teilgehäuse (201-205, 301-304) unter Zugabe von Sauerstoff, Stickstoff, Kohlendioxid, Xenon, Argon, Krypton, Chlor, Brom oder Mischungen davon erfolgt.

8. Optische Anordnung nach Anspruch 6 oder 7, **dadurch gekennzeichnet, dass** dieses Teilgehäuse wenigstens eines der optischen Elemente im Projektionsobjektiv der Projektionsbelichtungsanlage umgibt.

9. Optische Anordnung nach Anspruch 6 oder 7, **dadurch gekennzeichnet, dass** dieses Teilgehäuse einen Kollektorspiegel einer Lichtquelle umgibt.

10. Optische Anordnung nach einem der vorhergehenden Ansprüche, **dadurch gekennzeichnet, dass**
- wenigstens ein in einem ersten Teilgehäuse befindliches optisches Element eine erste Kontaminationsschutzdeckschicht (413) aufweist, und
- wenigstens ein in einem zweiten Teilgehäuse befindliches optisches Element eine zweite Kontaminationsschutzdeckschicht (423) aufweist,
- wobei diese Kontaminationsschutzdeckschichten (413, 423) sich hinsichtlich des jeweiligen Schichtmaterials voneinander unterscheiden.

11. Optische Anordnung in einem optischen System, insbesondere in einer Projektionsbelichtungsanlage für die EUV-Lithographie, mit:
• einem Gehäuse, in welchem eine Mehrzahl von optischen Elementen angeordnet ist; und
• einer Mehrzahl von innerhalb dieses Gehäuses angeordneten Teilgehäusen (201-205, 301-304);
• wobei wenigstens ein in einem ersten Teilgehäuse befindliches optisches Element eine erste Kontaminationsschutzdeckschicht (413) aufweist, und
• wobei wenigstens ein in einem zweiten Teilgehäuse befindliches optisches Element eine zweite Kontaminationsschutzdeckschicht (423) aufweist, wobei diese Kontaminationsschutzdeckschichten (413, 423) sich hinsichtlich des jeweiligen Schichtmaterials voneinander unterscheiden.

12. Optische Anordnung nach Anspruch 10 oder 11, **dadurch gekennzeichnet, dass** die erste Kontaminationsschutzdeckschicht (413) und/oder die zweite Kontaminationsschutzdeckschicht (423) ein Schichtmaterial aus der Gruppe aufweist, die Yttrium (Y), Cer (Ce), Zirkon (Zr), Niob (Nb), Silizium (Si), Titan (Ti), Vanadium (V), Molybdän (Mo), Mangan (Mn), Aluminium (Al), Wolfram (W), Chrom (Cr), Lanthan (La), Kobalt (Co), Ruthenium (Ru), Bor (B), Hafnium (Hf), Uran (U), Beryllium (Be) sowie Oxide, Nitride, Karbide, Silikate und Boride aus diesen Materialien enthält.

13. Optische Anordnung nach einem der Ansprüche 10 bis 12, **dadurch gekennzeichnet, dass** das erste Teilgehäuse wenigstens eines der optischen Elemente in der Beleuchtungseinrichtung der Projektionsbelichtungsanlage umgibt.

14. Optische Anordnung nach einem der Ansprüche 10 bis 13, **dadurch gekennzeichnet, dass** das zweite Teilgehäuse wenigstens eines der optischen Elemente im Projektionsobjektiv der Projektionsbelichtungsanlage umgibt.

15. Optische Anordnung nach einem der vorhergehenden Ansprüche, **dadurch gekennzeichnet, dass** diese für eine Arbeitswellenlänge von weniger als 15 nm ausgelegt ist.

16. Mikrolithographische Projektionsbelichtungsanlage, mit einer Beleuchtungseinrichtung und einem Projektionsobjektiv, wobei die Beleuchtungseinrichtung und/oder das Projektionsobjektiv eine optische Anordnung nach einem der vorhergehenden Ansprüche aufweist.

17. Verfahren zur mikrolithographischen Herstellung mikrostrukturierter Bauelemente mit folgenden Schritten:
• Bereitstellen eines Substrats, auf das zumindest teilweise eine Schicht aus einem lichtempfindlichen Material aufgebracht ist;
• Bereitstellen einer Maske (121), die abzubildende Strukturen aufweist;
• Bereitstellen einer mikrolithographischen Projektionsbelichtungsanlage (100) nach Anspruch 16; und
• Projizieren wenigstens eines Teils der Maske (121) auf einen Bereich der Schicht mit Hilfe der Projektionsbelichtungsanlage.
